# EUROPEAN PATENT APPLICATION

(11) **EP 4 766 138 A2**
(43) Date of publication of application: **24.06.2026**
(21) Application number: 25220596.8
(22) Date of filing: 03.12.2025
(51) Int. Cl.: H10W 42/20, H10W 74/10

(54) **STACKED PACKAGE**

(30) Priority: 18.12.2024 TW 113149327
(71) Applicant: Chipbond Technology Corporation, Hsinchu City (TW)
(72) Inventor: SHIH, Cheng-Hung, Zhudong Township, Hsinchu County (TW); HSIEH, Yung-Wei, Hsinchu City (TW); CHENG, Pai-Sheng, Hsinchu City (TW); CHIANG, Chih-Hao, Hsinchu City (TW)
(74) Representative: Beck & Rössig European Patent Attorneys

(57) **Abstract**

A stacked package includes a substrate (110), conductive pillars (122), a semiconductor element (150), electronic elements (130) and an encapsulant (140). An electronic element mounting area (111B) and a conductive pillar mounting area (111C) are defined on a surface of the substrate, the conductive pillar mounting area is located between the electronic element mounting area and one of edges of the surface. The conductive pillars are mounted only on the conductive pillar mounting area and electrically connected to the substrate and the semiconductor element, thus the electronic elements can be mounted on the electronic element mounting area where without the conductive pillars to improve electronic performance of the stacked package. The encapsulant is provided between the substrate and the semiconductor element to encapsulate the conductive pillars and the electronic elements and support the semiconductor element.

## Description

### FIELD OF THE INVENTION

This invention relates to a stacked package, and more particularly to a stacked package with improved electrical performances.

### BACKGROUND OF THE INVENTION

For smaller and smaller electronic products with increased electronic performance, size of semiconductor package has to be decreased. As a result, it is necessary to find a solution to mount electronic elements with different functions on a substrate having restricted space.

### SUMMARY OF THE INVENTION

One object of the present invention is to provide a stacked package with improved electronic performance which includes electronic elements mounted in a space between a substrate and a semiconductor element according to electronic requirement.

A stacked package of the present invention includes a substrate, conductive pillars, a semiconductor element, electronic elements and a first encapsulant. A first surface of the substrate has more than one edges, at least one electronic element mounting area and a conductive pillar mounting area are defined on the first surface of the substrate, and the conductive pillar mounting area is located only between one of the edges and the electronic element mounting area. The conductive pillars are mounted only on the conductive pillar mounting area, and a first end of each of the conductive pillars is electrically connected to the substrate. A second surface of the semiconductor element faces toward the first surface of the substrate, and a first bonding area and a second bonding area are defined on the second surface of the semiconductor element. A second end of each of the conductive pillars is bonded to the first bonding area and electrically connected to the semiconductor element. The second bonding area is located above the electronic element mounting area such that there is a space formed between the second bonding area and the electronic element mounting area. The electronic elements are mounted on the electronic element mounting area where without the conductive pillars and they are located in the space. The first encapsulant is provided between the substrate and the semiconductor element to cover the conductive pillars and the electronic elements located within the space and is configured to support the second bonding area without bonding to the conductive pillars.

The conductive pillar mounting area of the substrate is designed to be located between the electronic element mounting area and one of the edges, and the conductive pillars are provided only on the conductive pillar mounting area. Thus, the space is formed between the electronic element mounting area of the substrate and the second bonding area of the semiconductor element, and the electronic elements can be provided in the space according to different electronic requirements to improve electronic performance of the stacked package.

### BRIEF DESCRIPTION OF DRAWING

Fig. 1 is a cross-section view diagram illustrating a substrate in accordance with one embodiment of the present invention.
Figs. 2A and 2B are top view diagrams illustrating a substrate in accordance with different embodiments of the present invention.
Fig. 3 is a cross-section view diagram illustrating conductive pillars and electronic elements mounted on a substrate in accordance with one embodiment of the present invention.
Figs. 4A and 4B are top view diagrams illustrating conductive pillars and electronic elements mounted on a substrate in accordance with different embodiments of the present invention.
Figs. 5A and 5B are cross-section view diagrams illustrating conductive pillars and electronic elements encapsulated by a first encapsulant in accordance with different embodiments of the present invention.
Fig. 6 is a cross-section view diagram illustrating a semiconductor element bonded to conductive pillars in accordance with one embodiment of the present invention.
Figs. 7A and 7B are cross-section view diagrams illustrating a stacked package with a heat dissipation layer before a cutting process in accordance with different embodiments of the present invention.
Figs. 8A and 8B are cross-section view diagrams illustrating a stacked package with a heat dissipation layer after a cutting process in accordance with different embodiments of the present invention.
Figs. 9A and 9B are cross-section view diagrams illustrating a stacked package with an electromagnetic shielding cover in accordance with different embodiments of the present invention.

### DETAILED DESCRIPTION OF THE INVENTION

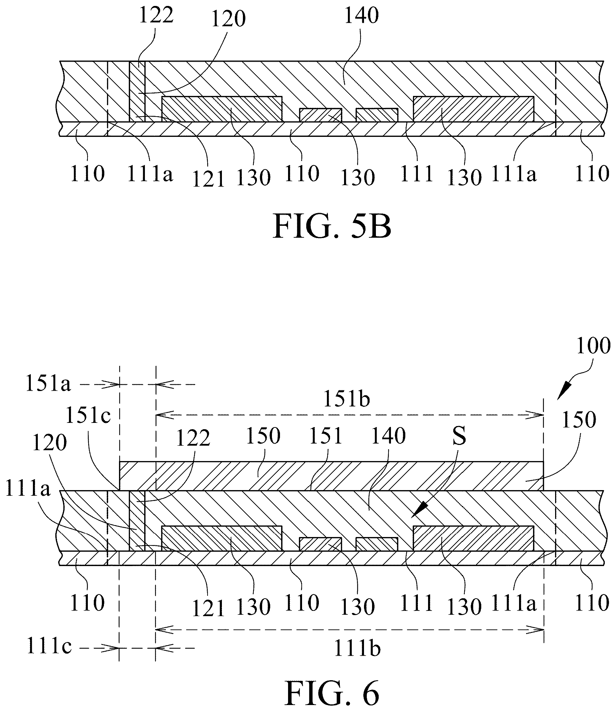

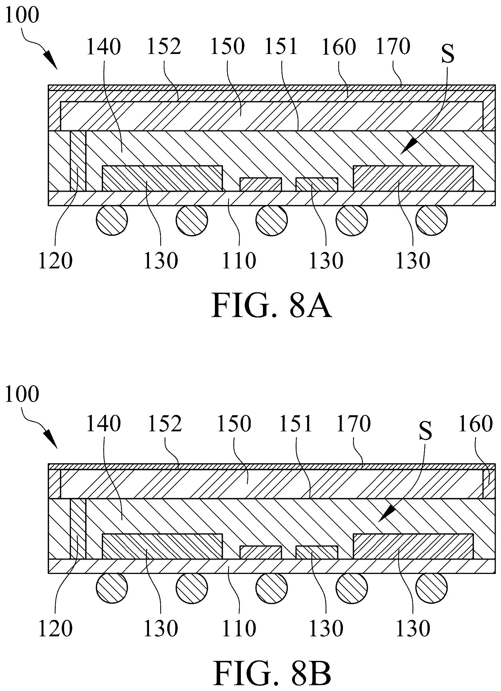

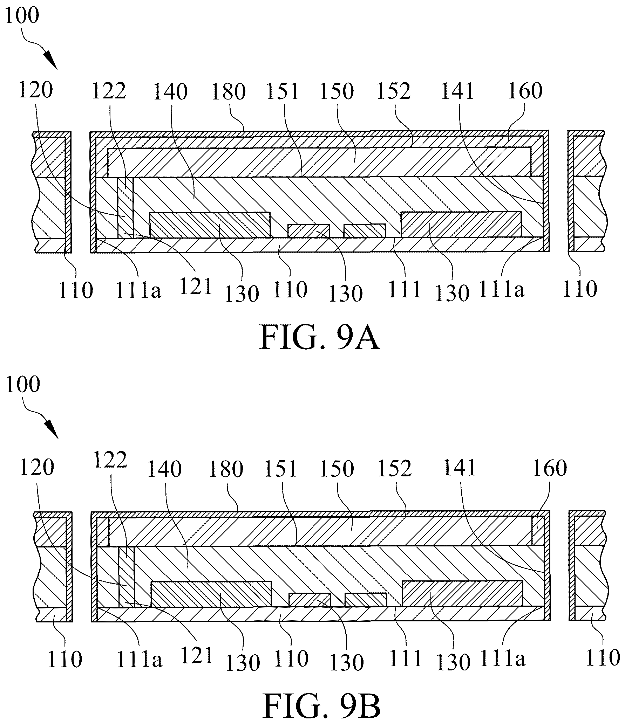

With reference to Fig. 6, a stacked package 100 in accordance with one embodiment of the present invention includes a substrate 110, conductive pillars 120, electronic elements 130, a first encapsulant 140 and a semiconductor element 150. In some embodiments, the stacked package 100 further includes a second encapsulant 160 and a heat dissipation layer 170 as shown in Figs. 8A and 8B. And in other embodiments, the stacked package 100 further includes a second encapsulant 160 and an electromagnetic shielding cover 180 as shown in Figs. 9A and 9B.

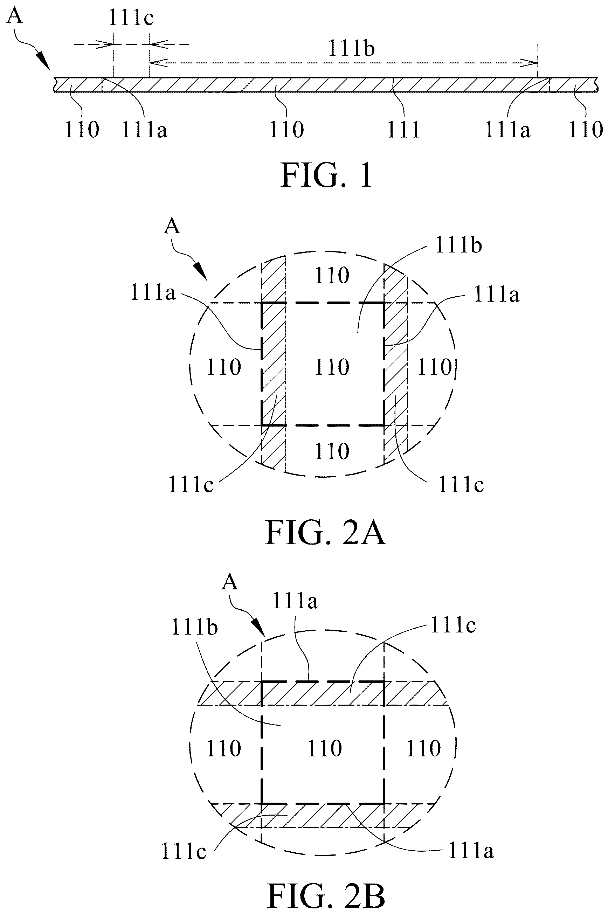

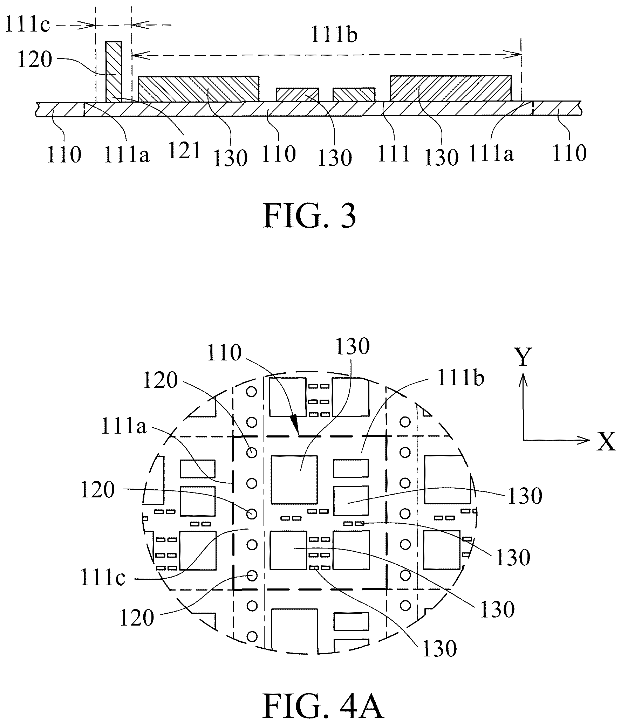

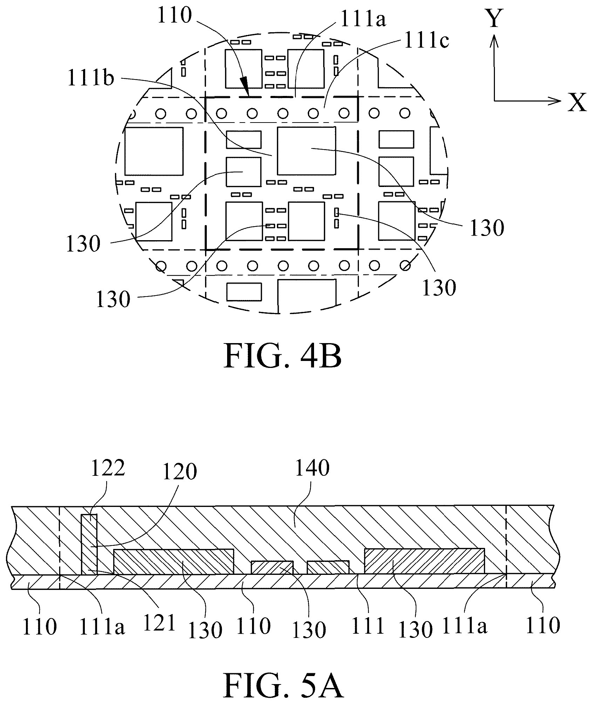

With reference to Figs. 1, 2A, 2B and 6, a first surface 111 of the substrate 110 has more than one edges 111a, and at least one electronic element mounting area 111b and only one conductive pillar mounting area 111c are defined on the first surface 111. The conductive pillar mounting area 111c is located between the electronic element mounting area 111b and one of the edges 111a of the first surface 111. The conductive pillars 120 are arranged only on the conductive pillar mounting area 111c along a direction, and a first end 121 of each of the conductive pillars 120 is electrically connected to the substrate 110. The conductive pillars 120 can be arranged on the conductive pillar mounting area 111c along a direction Y (vertical) in one embodiment as shown in Fig. 4A and along another direction X (horizontal) in another embodiment as shown in Fig. 4B.

With reference to Fig. 6, a second surface 151 of the semiconductor element 150 faces toward the first surface 111 of the substrate 110, and a first bonding area 151a and a second bonding area 151b are defined on the second surface 151. A second end 122 of each of the conductive pillars 120 is bonded to the first bonding area 151a and electrically connected to the semiconductor element 150. In this embodiment, the first bonding area 151a is adjacent to an edge 151c of the second surface 151, located between the edge 151c and the second bonding area 151b and located above the conductive pillar mounting area 111c. The second bonding area 151b is located above the electronic element mounting area 111b such that a space S is formed between the second bonding area 151b and the electronic element mounting area 111b.

With reference to Fig. 6, the electronic elements 130 are mounted on the electronic element mounting area 111b and located within the space S. The first encapsulant 140 is provided between the substrate 110 and the semiconductor element 150 to cover the conductive pillars 120 and the electronic elements 130 located in the space S, and the first encapsulant 140 can support the second bonding area 151b where without the conductive pillars 120.

Figs. 1 to 9B are provided to illustrate a method of manufacturing the stacked package 100. With reference to Fig. 1, a carrier A which may be wafer, circuit board or glass substrate is provided firstly, and it can be placed on an adhesive tape (not shown) for subsequent manufacturing processes. The carrier A involves multiple substrates 110 connected to one another, the first surface 111 of each of the substrates 110 has the edges 111a, and the electronic element mounting area 111b and the conductive pillar mounting area 111c are defined on the first surface 111. Referring to Fig. 2A or 2B, the conductive pillar mounting area 111c is only located between the electronic element mounting area 111b and one of the edges 111a of the first surface 111.

With reference to Figs. 3, 4A and 4B, the conductive pillars 120 are mounted on the conductive pillar mounting area 111c, and the electronic elements 130 are mounted on the electronic element mounting area 111b. The conductive pillars 120 are, but not limit to, made of copper, and each of them is electrically connected to the substrate 110 via its first end 121. The electronic elements 130 are electrically connected to the substrate 110 and they can be chips, filters, passive elements, or other electronic elements depending on different electronic requirements.

The conductive pillars 120 are arranged on the conductive pillar mounting area 111c along a direction. In one embodiment as shown in Fig. 4A, the conductive pillars 120 are arranged on the conductive pillar mounting area 111c along the direction Y (vertical). In another embodiment as shown in Fig. 4B, the conductive pillars 120 are arranged on the conductive pillar mounting area 111c along the direction X (horizontal). The electronic elements 130 are provided on the electronic element mounting area 111b where without the conductive pillars 120 according to different electronic requirements.

With reference to Fig. 5A, in one embodiment, the first encapsulant 140 is provided to encapsulate the conductive pillars 120 and the electronic elements 130 and cover the second end 122 of each of the conductive pillars 120, then the first encapsulant 140 is ground to expose the second end 122. With reference to Fig. 5B, in another embodiment, the first encapsulant 140 is provided to encapsulate the conductive pillars 120 and the electronic elements 130, and the first encapsulant 140 does not cover the second end 122 of each of the conductive pillars 120.

With reference to Fig. 6, next, the semiconductor element 150 is provided to bond to the second end 122 of each of the conductive pillars 120. The first bonding area 151a and the second bonding area 151b are defined on the second surface 151 of the semiconductor element 150. The second surface 151 of the semiconductor element 150 is faced toward the first surface 111 of the substrate 110 to allow the second end 122 of each of the conductive pillars 120 to be bonded to the first bonding area 151a such that the conductive pillars 120 are electrically connected to the semiconductor element 150. The space S is formed between the electronic element mounting area 111b of the substrate 110 and the second bonding area 151b of the semiconductor element 150, and it is provided for placements of the electronic elements 130 and the first encapsulant 140. The first encapsulant 140 is not only provided to encapsulate the conductive pillars 120 and the electronic elements 130, but also provided to support the second bonding area 151b where without the conductive pillars 120.

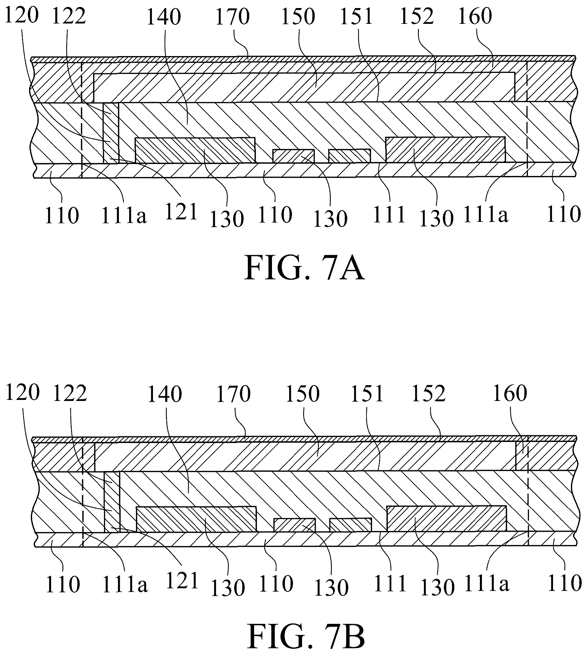

With reference to Fig. 7A, the semiconductor element 150 is encapsulated by the second encapsulant 160, and in this embodiment, another surface 152 of the semiconductor element 150 is covered by the second encapsulant 160. Next, the heat dissipation layer 170 is formed on the second encapsulant 160 for heat dissipation. With reference to Fig. 8A, a cutting process is performed to separate the stacked packages 100.

With reference to Fig. 7B, the second encapsulant 160 is provided to encapsulate the semiconductor element 150 and cover the surface 152 of the semiconductor element 150. In this embodiment, the second encapsulant 160 can be ground to expose the surface 152 of the semiconductor element 150, then the heat dissipation layer 170 is provided on the exposed surface 152 of the semiconductor element 150, and the cutting process is performed at last to separate the stacked packages 100 as shown in Fig. 8B.

With reference to Fig. 9A, in another embodiment, after the semiconductor element 150 is encapsulated by the second encapsulant 160, the cutting process is performed to separate the stacked packages 100, then the electromagnetic shielding cover 180 is formed on each of the stacked packages 100 to cover the second encapsulant 160 and a side wall 141 of the first encapsulant 140 such that the electromagnetic shielding cover 180 is electrically connected to the substrate 110.

With reference to Fig. 9B, the second encapsulant 160 encapsulates the semiconductor element 150 and is ground to expose the surface 152 of the semiconductor element 150, then the cutting process is performed to separate the stacked packages 100, and the electromagnetic shielding cover 180 is formed on each of the stacked packages 100. In this embodiment, the electromagnetic shielding cover 180 covers the second encapsulant 160, the surface 152 of the semiconductor element 150 and the side wall 141 of the first encapsulant 140, and it is electrically connected to the substrate 110.

In the present invention, the conductive pillar mounting area 111c is located only between the electronic element mounting area 111b and one of the edges 111a of the first surface 111, and the conductive pillars 120 are provided only on the conductive pillar mounting area 111c. Accordingly, the area of the electronic element mounting area 111b of the substrate 110 can be increased, the space S can be formed between the electronic element mounting area 111b of the substrate 110 and the second bonding area 151b of the semiconductor element 150, and the electronic elements 130 can be provided in the space S based on different electronic requirements to improve the electronic performance of the stacked package 100.

While this invention has been particularly illustrated and described in detail with respect to the preferred embodiments thereof, it will be clearly understood by those skilled in the art that is not limited to the specific features shown and described and various modified and changed in form and details may be made without departing from the scope of the claims.

## Claims

1. A stacked package (100) comprising:
a substrate (110) having a first surface (111), an electronic element mounting area (111b) and a conductive pillar mounting area (111c) are defined on the first surface (111), wherein
the conductive pillar mounting area (111c) is located only between the electronic element mounting area (111b) and one of a plurality of edges (111a) of the first surface (111);
a plurality of conductive pillars (120) mounted on the conductive pillar mounting area (111c) only, a first end (121) of each of the plurality of conductive pillars (120) is electrically connected to the substrate (110);
a semiconductor element (150) having a second surface (151) facing toward the first surface (111) of the substrate (110), a first bonding area (151a) and a second bonding area (151b) are defined on the second surface (151), a second end (122) of each of the plurality of conductive pillars (120) is bonded to the first bonding area (151a) and electrically connected to the semiconductor element (150), wherein the second bonding area (151b) is located above the electronic element mounting area (111b), and there is a space (S) between the second bonding area (151b) and the electronic element mounting area (111b);
a plurality of electronic elements (130) mounted on the electronic element mounting area (111b) where without the plurality of conductive pillars (120), the plurality of electronic elements (130) are located in the space (S); and
a first encapsulant (140) provided between the substrate (110) and the semiconductor element (150) to cover the plurality of conductive pillars (120) and the plurality of electronic elements (130) located in the space (S), wherein the first encapsulant (140) is configured to support the second bonding area (151b) where without the plurality of conductive pillars (120).

2. The stacked package (100) in accordance with claim 1, wherein the plurality of conductive pillars (120) are arranged on the conductive pillar mounting area (111c) along a direction (X or Y).

3. The stacked package (100) in accordance with claim 1 or 2 further comprising a second encapsulant (160) and a heat dissipation layer (170), wherein the semiconductor element (150) is encapsulated by the second encapsulant (160), and the heat dissipation layer (170) is formed on the second encapsulant (160).

4. The stacked package (100) in accordance with claim 3, wherein a surface (152) of the semiconductor element (150) is visible from the second encapsulant (160), and the heat dissipation layer (170) is formed on the surface (152) of the semiconductor element (150).

5. The stacked package (100) in accordance with claim 1 or 2 further comprising a second encapsulant (160) and an electromagnetic shielding cover (180), wherein the semiconductor element (150) is encapsulated by the second encapsulant (160), the second encapsulant (160) and a side wall (141) of the first encapsulant (140) are covered by the electromagnetic shielding cover (180), and the electromagnetic shielding cover (180) is electrically connected to the substrate (110).

6. The stacked package (100) in accordance with claim 5, wherein a surface (152) of the semiconductor element (150) is visible from the second encapsulant (160) and is covered by the electromagnetic shielding cover (180).

7. The stacked package (100) in accordance with one of claims 1 to 6, wherein the first bonding area (151a) is adjacent to an edge (151c) of the second surface (151) of the semiconductor element (150), located between the second bonding area (151b) and the edge (151c) of the second surface (151) of the semiconductor element (150), and located above the conductive pillar mounting area (111c).
